Europäisches Patentamt

European Patent Office

Office européen des brevets

(19)

(11) Veröffentlichungsnummer : **0 290 776 B1**

# EUROPÄISCHE PATENTSCHRIFT

(12)

(45) Veröffentlichungstag der Patentschrift :
**15.05.91 Patentblatt 91/20**

(51) Int. Cl.⁵ : **D06F 75/26**

(21) Anmeldenummer : **88105348.2**

(22) Anmeldetag : **02.04.88**

(54) **Sicherheitsschalteinrichtung zur Steuerung eines Stromverbrauchers.**

(30) Priorität : **09.05.87 DE 3715497**

(43) Veröffentlichungstag der Anmeldung :
**17.11.88 Patentblatt 88/46**

(45) Bekanntmachung des Hinweises auf die
Patenterteilung :
**15.05.91 Patentblatt 91/20**

(84) Benannte Vertragsstaaten :
**AT CH DE ES FR GB IT LI NL**

(56) Entgegenhaltungen :
**WO-A-82/03520**

(56) Entgegenhaltungen :
**WO-A-84/03186**
**WO-A-86/01953**
**DE-A- 1 566 695**
**DE-A- 3 146 152**
**US-A- 4 203 101**

(73) Patentinhaber : **Braun Aktiengesellschaft**
**Rüsselsheimer Strasse 22**
**W-6000 Frankfurt/Main (DE)**

(72) Erfinder : **Heuwinkel, Lothar, Dr.**
**Im Hirtengarten 44**
**W-6239 Eppstein 2 (DE)**
Erfinder : **Hofinger, Herbert**
**Falkenweg 11**
**W-6370 Oberursel 4 (DE)**

## Beschreibung

Die Erfindung bezieht sich auf eine Sicherheitsschalteinrichtung zur Steuerung der Spannungsversorgung eines von Hand geführten Elektrogerätes, insbesondere eines Bügeleisens.

Eine derartige Schalteinrichtung für ein Bügeleisen ist beispielsweise aus der DE-OS 28 44 089 bekannt. Bei dieser Sicherheitsschalteinrichtung ist im Handgriff des Bügeleisens ein Tastschalter vorgesehen, der zur Steuerung der Spannungsversorgung einer in der Bügeleisensohle ausgebildeten Heizeinrichtung über einen an der Unterseite des Handgriffs angeordneten, federbelasteten Bedienungshebel ein- und ausgeschaltet werden kann. Der Bedienungshebel ragt an der Unterseite des Handgriffs aus dessen Kontur nach unten hervor. Beim Umgreifen des Handgriffs des Bügeleisens wird der Bedienungshebel von der Hand des Benutzers gegen eine Federkraft in den Handgriff eingedrückt, so daß der Tastschalter betätigt wird. Hierdurch wird die Stromzufuhr zur Heizeinrichtung freigegeben. Zur Erfassung der senkrechten oder waagerechten Lage des Bügeleisens ist eine lageempfindliche Abtastvorrichtung vorgesehen, die in Form eines im Handgriff und senkrecht zur Bügeleisensohle angeordneten Quecksilberschalters realisiert ist. Befindet sich das Bügeleisen in seiner waagerechten Arbeitsposition, so ist die Spannungsversorgung über diesen lageabhängigen Schalter dann unterbrochen, wenn der Tastschalter nicht betätigt wird. Wird das Bügeleisen in seine senkrechte Lage gebracht, so wird die Spannungsversorgung unabhängig von einer Betätigung des Bedienungshebels des Tastschalters über den Quecksilberschalter dauernd aufrecht erhalten.

Diese Ausführungsform einer in einem Bügeleisen ausgebildeten Sicherheitsschalteinrichtung erfordert vom Benutzer das Aufbringen eines zusätzlichen Fingerdrucks, was wegen Ermüdungserscheinungen als nachteilig anzusehen ist und den Bedienungskomfort des Bügeleisens nachteilig beeinträchtigt. Derartige Schalter und deren Betätigungshebel können weiterhin aufgrund auftretender Verschmutzung und hoher Schalthäufigkeit leicht defekt werden, was zum Ausfall des Bügeleisens führt. Solche Sicherheitsschalteinrichtungen stellen darüber hinaus ein Sicherheitsrisiko dar, weil dann, wenn der Tastschalter aufgrund eines Defekts fälschlicherweise geschlossen bleibt, die Spannungsversorgung in der waagerechten Lage des Bügeleisens nicht unterbrochen wird, obgleich der Benutzer darauf vertraut.

Aus der WO-A-82 035 20 ist eine insbesondere für ein Bügeleisen verwendbare Sicherheitsschalteinrichtung bekannt, die ihrerseits eine Einrichtung enthält, welche selbsttätig prüft, ob sich das betreffende Gerät in Benutzung befindet oder nicht. Die Arbeitsweise dieser als "use-detector" bezeichneten Einrichtung kann auf zahlreichen verschiedenen Methoden beruhen, die alle aber geeignet sein müssen, den Zustand der Benutzung des Geräts vom Zustand der Nichtbenutzung zu unterscheiden.

So wird in der genannten Druckschrift neben dem bereits aus der DE-A 28 44 089 bekannten, im Handgriff eines Bügeleisens angeordneten Tastschalter ein piezoelektrisches Element beschrieben, auf welches die bei der Benutzung des Bügeleisens auftretenden Bewegungen des Versorgungskabels mechanisch einwirken und welches dann seinerseits unter Ausnutzung des piezoelektrischen Effekts elektrische Spannungen erzeugt, deren Auftreten eine Benutzung des Bügeleisens anzeigt. Als weitere "use-detector"-Einrichtungen werden Dehnungsmeßeinrichtungen, Beschleunigungsmesser, fotoelektrische und magnetische Sensoren genannt. Das von einer derartigen Einrichtung erzeugte Signal wird bei Anwendung der Sicherheitsschalteinrichtung bei einem Bügeleisen einem Timerschaltkreis zugeführt, dessen stets in Betrieb sich befindlicher Timer durch das Signal wieder auf Null zurückgesetzt wird. Tritt innerhalb einer wählbaren Zeitspanne kein Rücksetzsignal auf, wird sicherheitshalber die Spannungsversorgung des Bügeleisens unterbrochen. Die aus der WO-A-82 035 20 bekannte Sicherheitsschalteinrichtung weist den Nachteil auf, daß bei waagerechter Lage des Bügeleisens die gewählte Zeitspanne, während deren Andauern die Spannungsversorgung auch ohne Bewegung des Bügeleisens aufrecht erhalten wird, bereits zulange sein kann, um besonders empfindliches Bügelgut sicher vor Beschädigung zu schützen.

Außerdem besteht der Nachteil, daß für den Fall, daß der "use-detector" nicht auf fotoelektrischer oder magnetischer Grundlage arbeitet, bewegliche mechanische Teile vorhanden sind, die einem bestimmten Verschleiß unterworfen sind. Für den Fall das der "use-detector" auf fotoelektrischer oder magnetischer Grundlage arbeitet, sind in der genannten Druckschrift keinerlei Angaben gemacht, wie Fremdeinflüsse, das heißt vorhandenes Umgebungslicht oder magnetische Störfelder ausgeschaltet werden können, um zu verhindern, daß das betreffende Gerät auch unbeabsichtigt mit Spannung versorgt wird.

Aus der DE-A 15 66 695 ist schließlich ein kontaktloser Tastschalter bekannt, dessen Einsatz auch im Handgriff eines Bügeleisens denkbar ist, und bei dem durch Reflexion eines Lichtstrahls auf eine lichtempfindliche Zelle fallendes Licht ein elektrischer Impuls ausgelöst wird. Dabei tritt der Lichtstrahl für den Fall, daß der Benutzer den Tastschalter nicht berührt, durch eine Öffnung aus dem allseitig geschlossenen Gehäuse des Tastschalters aus. Für den Fall, daß der Benutzer diese Öffnung beispielsweise durch seine Hand abdeckt, wird der Lichtstrahl so reflektiert, daß er auf eine lichtempfindliche Zelle trifft, die ansonsten von einer Abschirmung gegen anderweitigen Lichteinfall geschützt wird.

Der Tastschalter nach der DE-A 15 66 695 weist den Nachteil, daß zur wirksamen Unterdrückung von Fremdlicht mehrere seinen Aufbau verkomplizierende Maßnahmen, wie der Einbau eines Filters, der Anbringung eines Licht absorbierenden Belags oder von Spiegeln getroffen werden müssen. Der bekannte Tastschalter ist dennoch kaum geeignet, Bestandteil einer Sicherheitsschalteinrichtung zu sein, da trotz all der genannten Maßnahmen nicht ausgeschlossen werden kann, daß er durch relativ starkes Fremdlicht dennoch "einschaltet" und damit Fehlfunktionen des betreffenden Geräts erzeugt. Er ist vielmehr nur als ein Schalter geeignet, dessen gelegentliche Fehlfunktion ohne nennenswerte Folge bleibt.

Aufgabe der Erfindung ist es daher, eine Sicherheitsschalteinrichtung für ein elektrisches Gerät, insbesondere für ein Bügeleisen anzugeben, die weder dem Verschleiß unterworfene mechanische Teile aufweist, noch durch fremde Signalquellen – bei einer auf optischer Grundlage arbeitenden Sicherheitsschalteinrichtung ist dies insbesondere Fremdlicht – derart beeinflußt werden kann, daß folgenschwere Fehl schaltungen auftreten. Es ist eine weitere Aufgabe der Erfindung, ein mitder erfindungsgemäßen Sicherheitsschalteinrichtung ausgestattetes Bügeleisen anzugeben, welches zur Vermeidung der Beschädigung auch von empfindlichem Bügelgut in seiner horizontalen Lage nur dann mit seiner Spannungsversorgung verbunden ist, wenn es von seinem Benutzer geführt oder zumindest berührt wird, welches aber dennoch auf seine Betriebstemperatur aufgeheizt werden kann, ohne daß es von seinem Benutzer dauernd berührt wird.

Die Aufgabe wird dadurch gelöst, daß die Sicherheitsschalteinrichtung eine Strahlungsquelle, einen außerhalb des Strahlungskegels der Strahlungsquelle angebrachten Detektor und eine Austrittsöffnung für die Strahlung aufweist, wobei der Detektor so angebracht ist, daß bei Abdeckung der Strahlungsquelle durch die Hand eines Benutzers Teile der Strahlung durch Reflexion auf den Detektor gelenkt werden und daß die Sicherheitsschalteinrichtung eine Auswertschaltung enthält, die bei auf den Detektor auftreffender Strahlung feststellt, ob es sich dabei um eine durch die Austrittsöffnung eingefallene Fremdstrahlung oder um eine von der Hand des Benutzers reflektierte Strahlung handelt und die beim Auftreten von reflektierter Strahlung den Stromverbraucher mit seiner Spannungsversorgung verbindet. Durch die Erfindung wird sichergestellt, daß das von der Strahlungsquelle emittierte Licht nur bei einer Berührung des Geräts durch den Benutzer durch Reflexion auf den Strahlungsdetektor gelangt. Trifft reflektierte Strahlung auf den Detektor, so wird über einen Hilfsstromkreis ein Schalter betätigt, durch den die Spannungsversorung freigegeben wird.

Um sicherzuzstellen, daß bei einem derartigen Aufbau der Sicherheitsschalteinrichtung die Spannungsversorgung nicht bereits durch Fremdlicht einschaltet bzw. eingeschaltet bleibt, ist es nach der Erfindung vorgesehen, daß die Strahl ungsquelle periodisch einund ausgeschaltet wird und daß für den Fall, daß bei eingeschalteter Strahlungsquelle an dem Detektor Strahlung registriert wurde, bei ausgeschalteter Strahl ungsquelle geprüft wird, ob der Detektor trotzdem von Strahlung beaufschlagt wird und nur für den Fall, daß am Detektor keine Strahlung registriert wird, der Stromverbraucher mit der Spannungsversorgung verbunden wird. Auf diese Weise wird stets sichergestellt, daß der Stromverbraucher nur dann eingeschaltet wird, wenn der Benutzer das Gerät tatsächlich bewegt oder zumindest seine Hand an dessen Handgriff aufgelegt hat.

Zur Vermeidung einer unnötigen Inbetriebnahme der Auswertschaltung ist es vorteilhaft, wenn diese erst dann aktiviert wird, wenn am Detektor tatsächlich auch Strahlung empfangen wird (Anspruch 2). Dies gilt insbesondere dann, wenn die Auswertschaltung durch einen Mikroprozessor (Anspruch 5) realisiert wird und dieser auch noch andere Funktionen bei der Steuerung des Bügeleisens zu übernehmen hat.

Eine besonders preisgünstige und einfach in einem Bügeleisen zu integrierende Sensoreinrichtung wird vorteilhafterweise dadurch erreicht, daß die Strahlungsquelle aus einer Fotodiode und der Detektor aus einem Fototransistor besteht (Anspruch 3). Damit beim Bügelvorgang die Hand des Benutzers tatsächlich die Sensoreinrichtung abdeckt, ist die Austrittsöffnung auf der Oberseite des Handgriffs angebracht (Anspruch 4). Durch diese Maßnahme wird sichergestellt, daß stets der großflächige Handbereich – und nicht nur ein einzelner Finger – die Austrittsöffnung zuverlässig abdeckt.

Eine besonders preiswerte und zuverlässig arbeitende Auswertschaltung kann mittels eines im Bügel eisen integrierten Mikrocomputers realisiert werden (Anspruch 5). Dies läßt sich in besonders einfacher Weise bei Bügeleisen realisieren, die bereits für die Steuerung anderer Funktionen, beispielsweise der zeitabhängigen Steuerung des Heizstroms durch nur einen Lagesensor, mit einem Mikrocomputer, wie z.B. einem Single-Chip-Computer, ausgestattet sind. Bei diesen Bügeleisen ist lediglich die Einprogrammierung der zusätzlichen Funktionen für die Auswertung der Reihenfolge der Potentiale an Lichtquelle und Detektor in den Mikrocomputer erforderlich.

Zur Lösung der weiteren Aufgabe der Erfindung wird das Bügeleisen beim Abstellen in seiner senkrechten Lage durch eine lageabhängige Einrichtung (Anspruch 6) in einem betriebsbreiten, beheizten Zustand gehalten, die die Sicherheitsschalteintung des Bügeleisens überbrückt. Befindet sich das Bügeleisen in seiner waagerechten Arbeitsposition, wird die Spannungsversorung dabei aber nach wie vor nur durch Berührung des Handgriffs durch den Benutzer gesteuert.

Schließlich ist es von Vorteil, als Einrichtung zur Aufrechterhaltung der Spannungsversorgung des Bügel ei sens in seiner senkrechten Lage, einen lageabhängigen elektrischen Schalter, beispielsweise einen preiswerten und dennoch sehr betriebssicheren Quecksilberschalter, zu verwenden (Anspruch 7). Ein Ausführungbeispiel der Erfindung ist der Zeichnung dargestellt und wird im folgenden näher erläutert. Es zeigen :

Fig. 1 Eine Seitenansicht eines schematisch dargestellten Bügeleisens mit Teilausschnitten der ersten und zweiten Abtastvorrichtung ;

Fig. 2 eine schematisch dargestellte Reflexionslichtschranke nach der Erfindung und

Fig. 3 einen schematisch dargestellen Schaltungsaufbau der erfindungsgemäßen Sicherheitsschalteinrichtung mit einer an einem Mikrocomputer angeschlossenen Reflexionslichtschranke nach Fig. 2.

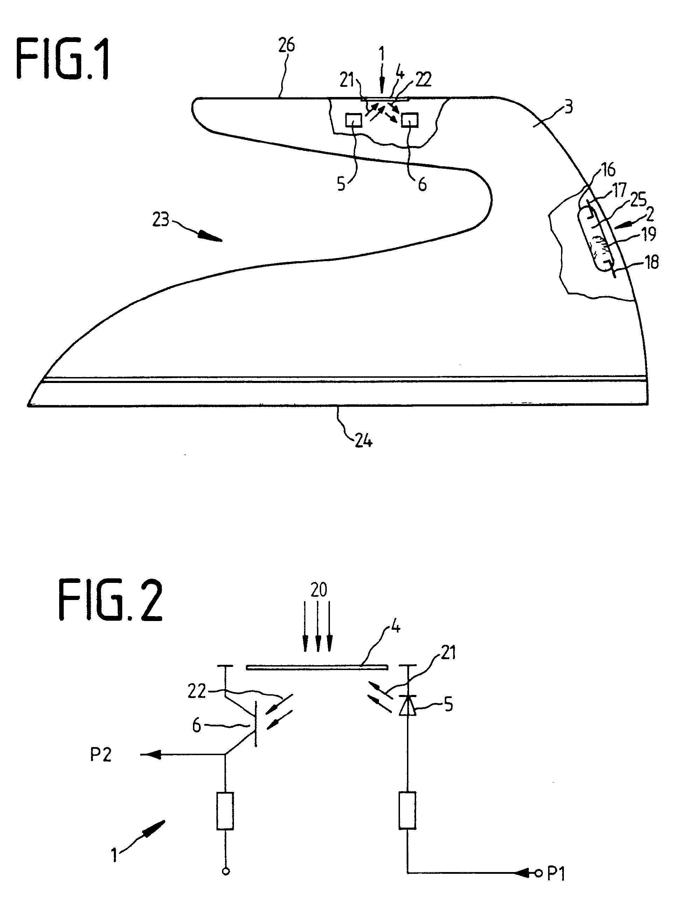

Die Figur 1 zeigt die Seitenansicht eines Bügeleisens 23 mit einer in einem Teilausschnit des Handgriffs 3 ausgebildeten, ersten Abtastvorrichtung 1, die dazu dient, festzustellen, ob der gang vom Handgriff 3 zum Sockel des Bügeleisens 23 ist im hinteren Bereich in einem weiteren Teilausschnitt eine zweite Abtastvorrichtung 2 vorgesehen, die für die Erfassung des Lagezustandes des Bügeleisens 23 dient.

Die zweite Abtastvorrichtung 2 besteht aus einem im wesentlichen senkrecht zur Bügeleisensohle 24 angeordneten Quecksilberschalter 25, der aus einem geschlossenen Glasröhrchen 16 besteht, in das an ihrem in der Zeichnung oberen und unteren Ende je eine Kontaktfahne 17, 18 hineinragt. Die im Glasröhrchen 16 liegenden Enden der Kontaktfahnen 17, 18 liegen soweit auseinander, daß in Bügelstellung, also in horizontaler Lage des Bügeleisens 23, die im Glasröhrchen 16 befindliche Quecksilberperle 19 beide Kontaktfahnen 17, 18 nicht miteinander verbindet, während diese in aufrechtstehender bzw. senkrechter Lage, d.h. in abgestellter Lage des Bügeleisens beide Kontaktfahnen 17, 18 miteinander verbindet un ein Stromfluß ermöglicht.

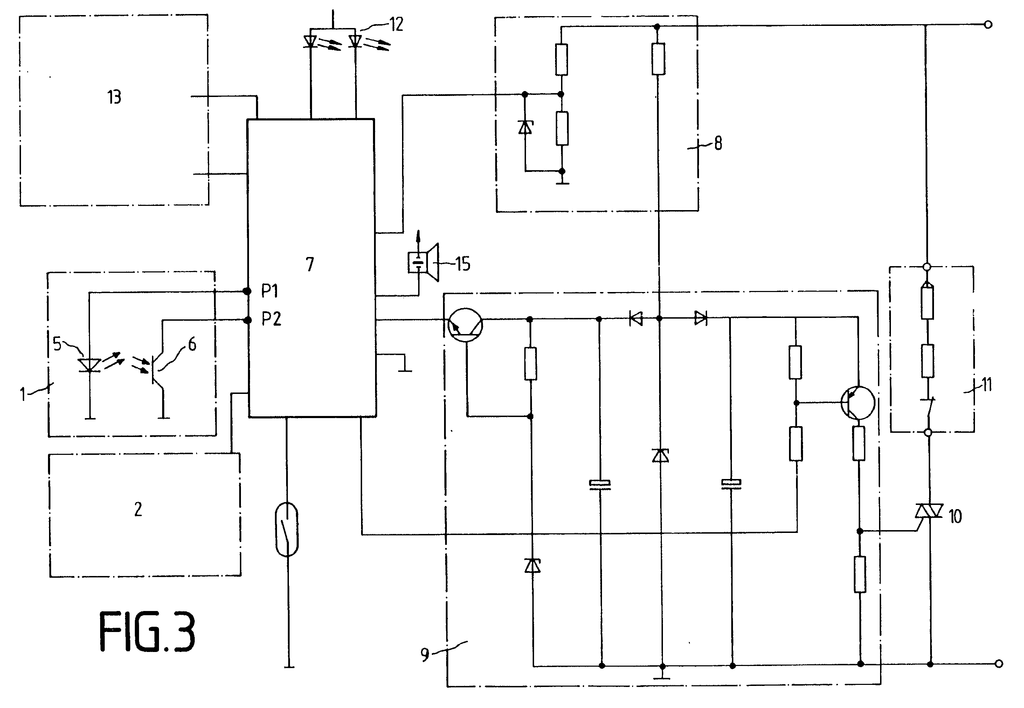

Die erste Abtastvorrichtung 1 ist nach den Fig. 1 und 2 in dem Handgriff 3 an der Oberseite 26 hinter einem Fenster 4 angeordnet und besteht aus einer lichtemittierenden Diode 5 und einem Phototransistor 6. Die lichtmittierenden Diode 5 ist derart angeordnet, daß ihr abgestrahltes Licht 21 unter einem Einfallwinkel schräg nach oben durch das lichtdurchlässige Fenster austritt, ohne den Phototransistor 6 zu beeinflussen. Wird das Bügeleisen 23 benutzt, so verdeckt die Hand des Benutzers das lichtdurchlässige Fenster 4 und reflektiert den Lichtstrahl 21 auf den Phototransistor 6 über den Lichtstrahl 22, der über einen Hilfsstromkreis einen in Heizstromkreis 11 (Fig. 3) des Bügeleisens 23 befindlichen Schalter betätigt und den Heizstrom auf die Heizwendel durchschaltet.

Bei der dargestellten Ausführungsform nach Fig. 1 ist das Fenster 4 an der oberen Seite des Handgriffs 3 angeordnet ; es ist aber auch jede andere räumliche Anordnung des Fensters 4 am Handgriff 3 möglich, sofern auch dort das Fenster 4 von der Hand eines Benutzers abgedeckt werden kann.

Die Fig. 2 zeigt schematisch den Aufbau und die Anordnung der Schaltelemente für die erste Abtastvorrichtung 1 mit der lichtemittierenden Diode 5, dem lichtdurchlässigen Fenster 4 und dem Phototransistor 6. Die von oben auf das Fenster 4 gerichteten Pfeile 20 stellen schematisch das von außen auf des Fenster 4 auftreffende Licht dar, wenn das Fenster 4 nicht von der Hand einer bügelnden Person verdeckt ist. Das Eingangssignal P1 schaltet die lichtemittierende Diode 5 ein, die einem Lichtstrahl 21 in der Zeichnung schräg auf des Fenster 4 aussendet. Der Phototransistor 6 liefert das Ausgangssignal P2 in Abhängigkeit vom Lichteinfall 22 auf den Phototransistor 6.

In Figur 3 wird anhand eines Blockschaltbildes dargestellt, wie eine Reflexionslichtschranke 1 gemäß der Erfindung mit einer Strahlungslichtquelle 5 und einen Detektor 6 in einem mit einem Single-Chip-Computer 7 ausgestatteten Bügeleisen 23 integriert werden kann. Der Single-Chip-Computer 7 erhält parallel zum Heizstromkreis 11 seine Spannung über ein Regelglied 8 und gibt seinerseits über einen Zündimpulsgeber 9 Zündimpulse an einen im Heizstromkreis 11 liegenden Triac 10. Dabei wird über den Triac 10 der Stromfluß zum Heizwendel des Heizstromkreises 11 so gesteuert, daß die errechnete oder die aus der Überwachungsschaltung abgeleitete Temperatur bzw. die hierfür notwendige Stromversorgung erreicht wird. Eingangsseitig wird der Single-Chip-Computer 7 von einem Temperaturmeßkreis 12, von einem Temperatureinstellschaltkreis 13, von der ersten Abtastvorrichtung 1 sowie von der zweiten Positionsabtastvorrichtung 2 gesteuert. Eine akustische oder optische Signaleinrichtung zum Anzeigen eines bestimmten Betriebszustandes des Bügeleisens 23 ist pauschal mit 15 bezeichnet.

Es liegt selbstverständlich im Rahmen des fachmännischen Könnens, die Programmierung des Single-Chip-Computers 7 so vorzunehmen, daß das durch die Erfindung vorgegebene Programm durchführbar ist. Ebenso kann der Detektor 6 so ausgebildet sein, daß er unterscheiden kann, ob tatsächlich eine Hand oder ein Tuch das Fenster 4 verdeckt.

Die anhand des Ausführungsbeispiels erläuterte Erfindung ist selbstverständlich in vielen Punkten modifizierbar. So kann beispielsweise zur Feststellung der Lage des Bügeleisens 23, also ob es sich in Arbeitslage oder in Hochkantlage befindet, auch eine elektro-optische Anordnung verwendet werden, indem an der Rückseite des Bügeleisens, an der es in seiner Hochkantlage abgestellt wird, eine nach der Erfindung baugleiche Abtastvorrichtung verwendet werden, da in Hochkantlage die Reflexion durch den Bügeltisch erfolgen kann.

Die Wirkungsweise des erfindungsgemäßen Bügeleisens ist folgende :

Sendet in horizontaler Lage des Bügeleisens 23 die Diode 5 kein Licht aus und empfängt der Phototransistor 6 auch kein Licht, so liegt kein Eigenlicht und auch kein Fremdlicht vor, d. h., die Heizung bleibt ausgeschaltet. Gibt die Diode 5 Licht ab und der Phototransistor empfängt kein Licht, so liegt kein Fremdlicht und keine Reflexion vor. Auch in diesem Fall bleibt die Heizung ausgeschaltet. Gibt die Diode 5 kein Licht ab und empfängt der Phototransistor 6 Licht, so liegt Fremdlicht vor, d.h., die Heizung bleibt ausgeschaltet. Gibt die Diode 5 Licht ab und empfängt der Phototransistor 6 Licht, so liegt entweder Reflexion oder Fremdlicht vor. Im Bruchteil einer Sekunde wird dann zur Überprüfung die Diode 5 ausgeschaltet. Empfängt nun der Phototransistor 6 Licht, so ist gewiß, daß Fremdlicht vorliegt. Empfängt der Phototransistor 6 aber in diesem Zustand kein Licht, so ist gewiß, daß eine Bedienungsperson ihre Hand am Handgriff 3 aufgelegt hat. Erst jetzt wird der Heizstromkreis 11 zur Heizeinrichtung freigegeben. Durch ständiges Ein- und Ausschalten der Diode 5 und gleichzeitigem Abfragen des Zustandes des Phototransistors 6 wird somit in einem Bruchteil einer Sekunde ermittelt, ob das Bügeleisen 23 von einer Bedienungsperson betätigt wird oder nicht.

## Ansprüche

1. Sicherheitschalteinrichtung zur Steuerung der Versorgungsspannung eines von Hand geführten Elektrogerätes, insbesondere eines Bügeleisens, **dadurch gekennzeichnet,** daß die Sicherheitsschalteinrichtung aus einer Strahlungsquelle (5), einem außerhalb deren Strahlungskegels (21) angebrachten Detektor (6) und einer Austrittsöffnung (4) für die Strahlung (21) aufweist, wobei der Detektor (6) so angebracht ist, daß bei Abdeckung der Austrittsöffnung durch die Hand eines Be nutzers Teile (22) der Strahlung (21) durch Reflexion auf den Detektor (6) gelenkt werden und daß die Sicherheitsschalteinrichtung die Strahlungsquelle (5) periodisch ein- und ausschaltet und eine Auswertschaltung enthält, die nur dann die Versorgungsspannung aufrecht erhält, wenn an dem Detektor (6) bei eingeschalteter Strahlungsquelle (5) Strahlung registriert und bei ausgeschalteter Strahlungsquelle (5) keine Strahlung mehr registriert wird, wobei die Periodendauer des Ein- und Ausschaltvorgangs der Strahlungsquelle (5) wesentlich kürzer ist, als die mittlere Zeitdauer, in der der Benutzer das Bügeleisen bei einem Bügelvorgang von Hand führt.

2. Sicherheitsschalteinrichtung nach Anspruch 1, **dadurch gekennzeichnet,** daß die Auswerteschaltung erst dann aktiviert wird, wenn am (6) Strahlung registriert wird.

3. Sicherheitsschalteinrichtung nach Anspruch 1, **dadurch gekennzeichnet,** daß die Strahlungsquelle (5) aus einer Photodiode und der Detektor (6) aus einem Phototransistor bestehen.

4. Sicherheitsschalteinrichtung nach Anspruch 1, **dadurch gekennzeichnet,** daß die Elektrogerät (23) einen Handgriff (3) aufweist, auf dessen Oberseite die Austrittsöffunung (4) angebracht ist.

5. Sicherheitsschalteinrichtung nach Anspruch 1, **dadurch gekennzeichnet,** daß die Auswerteschaltung mit Hilfe eines Mikrocomputer (7) dargestellt wird, der gleichzeitig die Steuerung des Stromverbrauchers (11) übernimmt.

6. Bügeleisen mit einer Sicherheitsschalteinrichtung nach Anspruch 1, **dadurch gekennzeichnet,** daß das Bügeleisen (23) in seiner senkrechten Lage, in der seine Bügeleisensohle (24) nicht in thermischem Kontakt mit dem Bügelgut steht, abgestellt werden kann und eine Einrichtung (2) aufweist, die in seiner senkrechten Lage unabhängig von der Sicherheitsschalteinrichtung (1) die Spannungsversorgung aufrecht erhält.

7. Bügeleisen nach Anspruch 6, **dadurch gekennzeichnet,** daß die Einrichtung (2) einen lageabhängigen elektrischen Schalter, beispiel sweise einen Quecksilberschalter (25) aufweist, dessen Kontaktfahnen (17, 18) nur in der senkrechten Lage des Bügeleisens (23) durch eine elektrisch leitende Flüssigkeit (19) miteinander verbunden sind und dadurch die Spannungsversorgung des Bügeleisens (23) aufrecht erhalten wird.

## Claims

1. A safety switching device for controlling the supply of voltage to a hand-held electrical appliance, in particular a smoothing iron, **characterized in that** the safety switching device includes a source of radiation (5), a detector (6) arranged outside the radiation cone (21) of the source of radiation and an exit opening (4) for the radiation (21), with the detector (6) being arranged such that with the exit opening covered by a user's hand, part (22) of the radiation (21) is directed to the detector (6) by reflection, and in that the safety switching device periodically activates and deactivates the source of radiation (5) and includes an evaluation circuitry which maintains the supply of voltage only if radiation is determined on the detector (6) with the source of radiation (5) turned on and no radiation is determined with the source of radiation (5) turned off, with the activation and deactivation period of the source of radiation (5) being substantially shorter than the mean period in which the user's hand guides the smoothing iron during an ironing operation.

2. The safety switching device as claimed in claim 1, **characterized in that** the evaluation circuitry is not activated until radiation is determined by the detector (6).

3. The safety switching device as claimed in claim 1, **characterized in that** the source of radiation (5) is comprised of a photodiode and the detector (6) is comprised of a phototransistor.

4. The safety switching device as claimed in claim 1, **characterized in that** the electrical appliance (23) includes a handle (3) having the exit opening (4) provided on the upper side thereof.

5. The safety switching device as claimed in claim 1, **characterized in that** the evaluation circuitry is accomplished by means of a microcomputer (7) which at the same time performs the function of controlling the power-consuming device (11).

6. A smoothing iron with the safety switching device as claimed in claim 1, **characterized in that** the smoothing iron (23) can be placed down in its vertical position in which its soleplate (24) is not in thermal contact with the item being ironed, and includes a device (2) which, with the iron in its vertical position, maintains the supply of voltage independent of the safety switching device (1).

7. The smoothing iron as claimed in claim 6, **characterized in that** the device (2) includes a position-dependent electric switch, for example, a mercury switch (25), whose contact tags (17, 18) are not in contact with each other by means of an electrically conducting liquid (19) until the smoothing iron (23) is in its vertical position, whereby the supply of voltage to the smoothing iron (23) is maintained.

**Revendications**

1. Dispositif de commutation de sécurité pour la commande de la tension d'alimentation d'un appareil électrique guidé manuellement, en particulier d'un fer à repasser, caractérisé en ce que le dispositif de commutation de sécurité possède une source de rayonnement (5), un détecteur (6) disposé en dehors du cône de rayonnement (21) de la source de rayonnement et une ouverture de sortie (4) du rayonnement (21), le détecteur (6) étant disposé de manière à ce que, lorsque l'ouverture de sortie est masquée par la main d'un utilisateur, une partie (22) du rayonnement (21) puisse être renvoyée sur le détecteur (6) par réflexion, et en ce que le dispositif de commutation de sécurité commute périodiquement la source de rayonnement (5) et comporte un circuit d'analyse qui ne maintient la tension d'alimentation que lorsque le détecteur (6) reçoit un rayonnement alors que la source de rayonnement (5) est en service et n'en reçoit plus lorsque la source de rayonnement (5) est coupée, la période des opérations de commutation de la source de rayonnement (5) étant beaucoup plus courte que la durée moyenne pendant laquelle un utilisateur guide le fer à repasser à la main dans une opération de repassage.

2. Dispositif de commutation de sécurité selon la revendication 1, caractérisé en ce que le circuit d'analyse n'est activé que lorsque le détecteur (6) enregistre un rayonnement.

3. Dispositif de commutation de sécurité selon la revendication 1, caractérisé en ce que la source de rayonnement (5) est constituée d'une photodiode et le détecteur (6) d'un phototransistor.

4. Dispositif de commutation de sécurité selon la revendication 1, caractérisé en ce que l'appareil électrique (23) possède une poignée (3) sur la face supérieure de laquelle est disposée l'ouverture de sortie (4).

5. Dispositif de commutation de sécurité selon la revendication 1, caractérisé en ce que le circuit d'analyse est réalisé sous la forme d'un micro-ordinateur (7) assurant simultanément la commande du consommateur de courant (11).

6. Fer à repasser avec un dispositif de commutation de sécurité selon la revendication 1, caractérisé en ce que le fer à repasser (23) peut être placé en position verticale, où sa semelle (24) ne se trouve pas en contact thermique avec l'étoffe à repasser et possède un dispositif (2) qui maintient la tension d'alimentation dans cette position verticale indépendamment du dispositif de commutation de sécurité (1).

7. Fer à repasser selon la revendication 6, caractérisé en ce que le dispositif (2) possède un commutateur électrique sensible à la position, par exemple un commutateur à mercure (25) dont les broches de contact (17, 18) ne sont reliées par un liquide conducteur électrique (19) que dans la position verticale du fer à repasser (23), ce qui maintient l'alimentation électrique du fer à repasser (23).

# FIG.1

# FIG.2

FIG.3

EP 0 290 776 B1